Europäisches Patentamt

European Patent Office

Office européen des brevets

(11) Veröffentlichungsnummer: **0 276 632 B1**

(19)

(12) **EUROPÄISCHE PATENTSCHRIFT**

(45) Veröffentlichungstag der Patentschrift: **11.09.91**

(51) Int. Cl.⁵: **H03D 1/18**, H03G 11/00

(21) Anmeldenummer: **87810748.1**

(22) Anmeldetag: **14.12.87**

(54) **Anordnung in einer integrierten Schaltung zum Erzeugen einer nichtlinearen Funktion.**

(30) Priorität: **23.12.86 CH 5189/86**

(43) Veröffentlichungstag der Anmeldung:
**03.08.88 Patentblatt 88/31**

(45) Bekanntmachung des Hinweises auf die
Patenterteilung:
**11.09.91 Patentblatt 91/37**

(84) Benannte Vertragsstaaten:
**AT BE CH DE FR GB IT LI NL SE**

(56) Entgegenhaltungen:
**WO-A-81/01921**
**DE-A- 2 651 813**

**MOTOROLA TECHNICAL DISCLOSURE BUL-
LETIN, Band 1, Nr. 1, August 1980, Seiten
33,34, Motorola Inc., Schaumburg, Illinois,
US; J. MILLER: "A two stage temperature
independent audio limiter"**

**IRE TRANSACTIONS ON ELECTRONIC COM-
PUTERS, Band EC-5, Nr. 4, Dezember 1956,
Seiten 203-206, New York, US; R.M. HOWE:
"Representation of nonlinear functions by
means of operational amplifiers"**

(73) Patentinhaber: **ASCOM AUTOPHON AG
Ziegelmattstrasse 1-15
CH-4503 Solothurn(CH)**

(72) Erfinder: **Häberle, Norbert
Römerweg 7
CH-4514 Lommiswil(CH)**
Erfinder: **Vollenweider, Walter
Weissensteinstrasse 47
CH-4500 Solothurn(CH)**

(74) Vertreter: **Schweizer, Hans et al
Bovard AG Patentanwälte VSP Optingenstrasse 16
CH-3000 Bern 25(CH)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft elektrische Schaltungen, die nichtlineare Verformungen von analogen Signale ermöglichen und für eine monolithische Integration geeignet sind. Sie beschränkt sich auf Gleichrichterschaltungen und Amplitudenbegrenzer.

Bei monolithisch integrierten analogen Signalverarbeitungssystemen stellt sich häufig die Aufgabe, obengenannte Funktionen einer ausreichenden Präzision zu erzeugen. Im allgemeinen kann dabei aus technologischen Gründen nicht auf bekannte Schaltungstechniken mit diskreten Bauelementen (Dioden, Widerstände, Operationsverstärker) zurückgegriffen werden, weshalb neue Lösungen gefunden werden müssen. Es sind einige Schaltungen bekannt, welche diese Funktionen erfüllen. Sie zeichnen sich alle dadurch aus, dass sie die Switched CapacitorSchaltungstechnik benützen, somit zeitdiskrete Schaltungen darstellen und ziemlich aufwendig sind. Beispiele solcher Schaltungen sind in

- Y. TSIVIDIS, P. ANTOGNETTI (EDITORS): "Design of MOS VLSI Circuits for Telecommunications", pp 386-393, Prentice-Hall, Inc., New Jersey, 1985, (ISBN 0-13-200643-X 01)
- R. GREGORIAN, K.W. MARTIN, G.G. TEMES: "Switched-Capacitor Circuit Design", pp 941-966, Proc. IEEE, vol. 71, August 1983
- B.J. HOSTICKA, W. BROCKHERDE, U. KLEINE, R. SCHWEER: "Design of Nonlinear Analog Switched-Capacitor Circuits using Building Blocks", pp 354-368, IEEE Trans. Circuits Syst., vol. CAS-31, April 1984
- PH.E. ALLEN, E. SANCHEZ-SINENCIO: "Switched Capacitor Circuits", pp 437-451, Van Nostrand Reinhold Company Inc., New York, 1984 (ISBN 0-442-20873-1)

enthalten.

Die Idee der Erfindung ist es nun, ein oder mehrere sehr einfache Schaltungselemente einzusezten, um die oben genannten nichtlinearen Funktionen zu realisieren. Es gelingt dadurch, sehr viel Platz zu sparen, was bei monolithischen Integrationen aus Kostengründen sehr wichtig ist. Ein weiteres Ziel war es, zeitkontinuierliche Schaltungen zu entwickeln, die gegenüber zeitdiskreten Problemlösungen den Vorteil haben, allgemeiner einsetzbar zu sein.

Die Aufgabe der Erfindung wird durch die kennzeichnenden Merkmale des Patentanspruchs 1 gelöst.

Die gewünschten nichtlinearen Schaltungen werden durch den Einsatz eines oder mehrerer Spannungsfolger mit mindestens zwei nichtinvertierenden Eingängen, wie sie bereits in der Patentschrift CH 655 819 A5 beschrieben werden, erzeugt. Mit diesen Schaltungselementen, die zeitkontinuierlich sind, gelingt es, nichtlineare Schaltungen zu realisieren, die einerseits nur einen Bruchteil des Platzes von zeitdiskreten Schaltungen benötigen, andererseits auch das übergeordnete System vereinfachen, weil keine Taktsignale nötig sind, ohne die die zitierten Switched CapacitorLösungen nicht auskommen.

In der Patentschrift CH 655 819 A5 werden diese Schaltungselemente in einer Anordnung eingesetzt, die Signalamplituden miteinander vergleicht, wobei die Spannungsfolger als Absolutwertbildner der Eingangssignale eingesetzt sind.

Im Gegensatz dazu verwendet sie die vorliegende Erfindung unter Zuhilfenahme von Gleichspannungen als Schaltungselemente, welche die Eingangssignale in geeigneter Weise beschneiden.

Die Erfindung wird nun anhand von zwei Ausführungsbeispielen erläutert:

Fig. 1 zeigt einen Halbwellengleichrichter,

Fig. 2 zeigt einen Amplitudenbegrenzer.

Dabei ist in den zugehörigen Diagrammen rechts neben bzw. unter den Schaltschemata jeweils die Spannung in Funktion der Zeit über bzw. auf oder unter der gestrichelten Mittel- oder Grundlinie ausgezogen dargestellt.

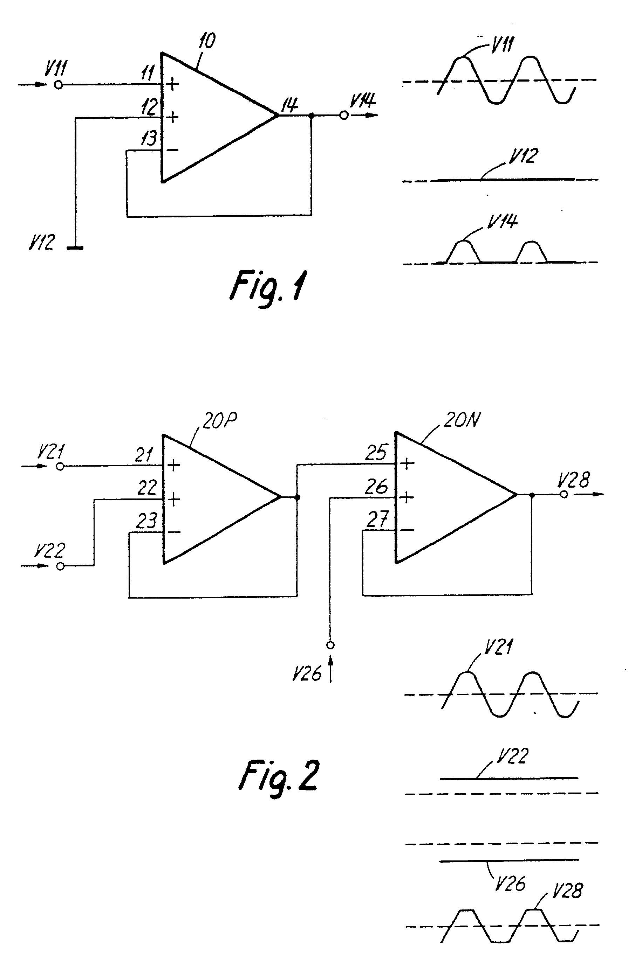

In der Fig. 1 ist ein Halbwellengleichrichter dargestellt, der als einziges Schaltungselement einen Spannungsfolger 10 mit zwei nichtinvertierenden Eingängen 11, 12 benötigt.

Ein nichtinvertierender Eingang 11 wird mit dem gleichzurichtenden Wechselspannungssignal V11 gespeist, der zweite nichtinvertierende Eingang 12 an die Spannung Null V12 gelegt. Am invertierenden Eingang 13 liegt die vom Ausgang 14 rückgekoppelte Ausgangsspannung V14.

Diese folgt den Signalanteilen von V11, die grösser sind als V12, ansonsten V14 gleich V12 ist.

Wenn nun dafür gesorgt ist, dass der Gleichspannungsanteil von V11 der Spannung V12 entspricht, wirkt die Schaltung Fig. 1 als Halbwellengleichrichter.

Der Amplitudenbegrenzer in Fig. 2 benötigt zwei Spannungsfolger 20P, 20N mit je zwei nichtinvertierenden Eingängen 21, 22; 25, 26, wobei die Eingangsstufe des einen Spannungsfolgers die duale Polarität des anderen besitzt (in Fig. 2 mit P resp. N im Spannungsfolgersymbol gekennzeichnet).

Die zu begrenzende Wechselspannung V21 wird dem ersten nichtinvertierenden Eingang 21 des ersten Spannungsfolgers 20P zugeführt; eine Gleichspannung V22, deren Wert der positiven Begrenzungsspannung entspricht, wird an den zweiten nichtinvertierenden Eingang 22 des ersten Spannungsfolgers gelegt.

Der Ausgang 24 des ersten Spannungsfolgers ist mit dessen invertierendem Eingang 23 und dem ersten nichtinvertierenden Eingang 25 des zweiten Spannungsfolgers 20N verbunden.

Eine zweite Gleichspannung V26, deren Wert der negativen Begrenzungsspannung entspricht, wird dem zweiten nichtinvertierenden Eingang 26 des zweiten Spannungsfolgers zugeführt.

Der Ausgang 28 des zweiten Spannungsfolgers ist auf dessen invertierenden Eingang 27 rückgekoppelt und stellt gleichzeitig den Ausgang des Amplitudenbegrenzers dar. Dessen Ausgangsspannung V28 folgt dem Eingangssignal V21, solange es sich innnerhalb der Grenzwerte V22, resp. V26 befindet, ansonsten entspricht sie einem dieser Grenzwerte, je nachdem, welcher Wert von V21 überschritten wurde.

## Patentansprüche

1. Anordnung in einer integrierten Schaltung mit mindestens einem Spannungsfolger, dessen Ausgang direkt mit dem invertierenden Eingang verbunden ist, zum veränderbaren Begrenzen der Amplitude von wenigstens einer Halbwelle einer an den nichtinvertierenden Eingang des Spannungsfolgers angelegten Wechselspannung, dadurch gekennzeichnet, dass der Spannungsfolger zwei im wesentlichen gleiche Eingangsdaten aufweisende, nichtinvertierende Eingänge umfasst, dass am ersten, nichtinvertierenden Eingang die Wechselspannung anliegt, und dass am zweiten nichtinvertierenden Eingang eine Gleichspannung anliegt, durch deren Grösse die Begrenzung der Amplituden von einer Halbwelle steuerbar ist.

2. Anordnung gemäss Anspruch 1, dadurch gekennzeichnet, dass am zweiten nichtinvertierenden Eingang des Spannungsfolgers eine Gleichspannung angelegt wird, deren Wert dem Gleichspannungsanteil des Wechselspannungssignals am ersten nichtinvertierenden Eingang entspricht.

3. Anordnung gemäss Anspruch 1, dadurch gekennzeichnet, dass sie zwei Spannungsfolger aufweist, deren Eingangsstufen zueinander duale Polarität besitzen, dass an den zweiten nichtinvertierenden Eingängen zwei Gleichspannungen angelegt sind, deren Differenzen zum Gleichspannungsanteil des Eingangssignals am ersten nichtinvertierenden Eingang des ersten Spannungswandlers den gleichen Absolutwert, aber duale Polarität aufweisen, dass die Polarität der Eingangsstufe jedes Spannungsfolgers mit der Polarität der genannten Differenz der angelegten Gleichspannung übereinstimmt und dass der Ausgang des ersten Spannungsfolgers mit dem ersten nichtinvertierenden Eingang des zweiten Spannungsfolgers verbunden ist.

## Claims

1. Arrangement in an integrated circuit with at least one voltage follower whose output is connected directly with the inverting input, to changeably limit the amplitude of at least one half-wave of an alternating voltage disposed at the non-inverting input of the voltage follower, characterized in that the voltage follower comprises two non-inverting inputs having essentially the same input data, in that the alternating voltage is applied at the first noninverting input and in that a direct voltage is applied at the second, non-inverting input, by means of whose size the limitation of the amplitudes of one half-wave is controllable.

2. Arrangement according to claim 1, characterized in that a direct voltage is applied at the second non-inverting input of the voltage follower, the value of which corresponds to the direct voltage portion of the alternating voltage signal on the first non-inverting input.

3. Arrangement according to claim 1, characterized in that it has two voltage followers whose input stages have dual polarity to each other, in that to the second non-inverting inputs are applied two direct voltages, whose differences have the same absolute value as the direct voltage portion of the input signal on the first non-inverting input of the first voltage converter, but have dual polarity, in that the polarity of the input stage of each voltage follower agrees with the polarity of the said difference of the direct voltage applied and in that the output of the first voltage follower is connected with the first non-inverting input of the second voltage follower.

## Revendications

1. Montage pour circuit intégré comprenant un suiveur de tension dont la sortie est directement reliée à l'entrée inversée pour limiter de façon variable l'amplitude d'au moins une alternance d'une tension alternative appliquée à l'entrée non inversée du suiveur de tension, caractérisé en ce que le suiveur de tension comprend deux entrées non inversées présentant pour l'essentiel les mêmes données d'entrée, en ce que la tension alternative est appliquée à la première entrée non inversée, et en ce qu'une tension continue est appliquée à la seconde entrée non inversée, la grandeur de cette tension continue commandant la limitation de l'amplitude d'une alternance.

2. Montage selon la revendication 1, caractérisé en ce qu'à la seconde entrée non inversée du suiveur de tension se trouve appliquée une tension continue dont la valeur correspond à la partie de tension continue du signal de tension alternative appliqué à la première entrée non inversée.

3. Montage selon la revendication 1, caractérisé en ce qu'il comprend deux suiveurs de tension dont les étages d'entrée ont des polarités complémentaires l'une à l'autre, en ce que sont appliquées sur les deuxièmes entrées non inversées deux tensions continues dont les différences par rapport à la partie à tension continue du signal d'entrée sur la première entrée non inversée du premier changeur de tension présentent la même valeur absolue mais avec des polarités contraires, en ce que la polarité de l'étage d'entrée de chaque suiveur de tension correspond à la polarité de ladite différence de la tension continue appliquée, et en ce que la sortie du premier suiveur de tension est reliée à la première entrée non inversée du deuxième suiveur de tension.

Fig.1

Fig.2